# EUROPEAN PATENT SPECIFICATION

(11) **EP 1 509 479 B1**
(45) Date of publication and mention of the grant of the patent: **05.08.2009**
(21) Application number: 03741847.2
(22) Date of filing: 03.06.2003
(51) Int. Cl.: C03C 3/091, C03C 3/093, C03B 17/06

(54) **LTCC TAPE COMPOSITION**
LTCC-SCHICHT-ZUSAMMENSETZUNG
COMPOSITION DE BANDE LTCC

(30) Priority: 04.06.2002 US 385697 P; 02.01.2003 US 336439; 30.01.2003 US 443785 P; 06.05.2003 US 430081
(43) Date of publication of application: 02.03.2005
(73) Proprietor: E.I. DU PONT DE NEMOURS AND COMPANY, Wilmington, DE 19898 (US)
(72) Inventor: CHO, Yong, Cary, NC 27519 (US); RELLICK, Joseph, Richard, Virginia, 22307 (US); HANG, Kenneth, Warren, Hillsborough, NC 27278 (US)
(74) Representative: Towler, Philip Dean
(86) International application number: PCT/US2003/017255
(87) International publication number: WO 2003/101902

(56) References cited:
- EP-A- 0 823 280
- US-A1- 2001 055 930
- US-A1- 2002 039 645

## Description

### FIELD OF THE INVENTION

The invention relates to a tape composition suitable for application to the manufacture of multilayer LTCC (Low Temperature Co-fired Ceramics) circuits. The tape exhibits broad process and materials compatibility with conductors and passive electronic materials when used to build high density LTCC circuits. The tape is non-toxic and suitable for use with conventional and Pb-free solders and plated metal circuit contact systems used in LTCC tape structures.

### BACKGROUND OF THE INVENTION

An interconnect circuit board of an LTCC design is a physical realization of electronic circuits or subsystems made from a number of extremely small circuit elements that are electrically and mechanically interconnected. It is frequently desirable to combine these diverse type electronic components in an arrangement so that they can be physically isolated and mounted adjacent to one another in a single compact package and electrically connected to each other and/or to common connections extending from the package. The use of an LTCC package and interconnects further extends for high frequency applications operating in the RF and microwave frequency range (300 kHz to 300 GHz) for audio, visual, and data transmission.

Complex electronic circuits generally require that the circuit be constructed of several layers of conductors separated by insulating dielectric layers. The conductive layers are interconnected between levels by electrically conductive pathways, called vias, through a dielectric layer. Such a multilayer structure allows a circuit to be more compact.

EPO823280 discloses a glass material for carrying a photocatalyst.

US2001/055930 discloses a method of making a halogen lamp bulb that minimizes contamination in the body of the glass.

The elimination of toxic materials from the chemical constituency of LTCC tape materials is a desired goal to reduce the environmental impact caused by public disposal of electronic materials in world wide community waste disposal systems. The tape fulfills this need.

### SUMMARY OF THE INVENTION

The invention is directed at a composition of an LTCC tape suitable for a wide variety of circuit manufacturing needs. Circuit materials that make up the glasses and ceramic tapes of this invention are free of elements, such as Pb and Cd, which are on the EPA hazardous waste list. The present invention relates to an alkali-alkaline earth-alumino-borosilicate glass composition comprising, in mole %, 46-66% SiO₂, 3-9% Al₂O₃, 5-9% B₂O₃, 0-8% MgO, 1-6% SrO, 11-22% CaO, and 2-8% M wherein M is selected from oxides of the group of alkali elements and mixtures thereof. Alkali elements are found in group IA of the periodic table. For example, the alkali element oxides may be represented by Li₂O, Na₂O, K₂O and mixtures thereof. The preferred alkaline earth oxides are selected from CaO, MgO and SrO. The molar ratio of SrO/ (Ca + MgO) is between about 0.06 to about 0.45. This ratio range is necessary to assure compatibility properties with conductor materials used in conjunction with the LTCC tape of this invention.

The invention is further directed to a castable dielectric composition comprising a dispersion of finely divided solids comprising, based on solids: (a) 40-80 wt. % the glass composition as described above; (b) 20-60 wt. % ceramic filler; both dispersed in a solution of (c) an organic polymeric binder; and (d) a volatile organic solvent.

The invention is further directed to the castable dielectric compostion as described above used as a thick film paste by such techniques as screen printing.

The invention is still further directed to the castable dielectric composition as described above used in a method of forming an LTCC green tape by casting a thin layer of the castable dispersion onto a flexible substrate and heating the cast layer to remove the volatile organic solvent.

### BRIEF DESCRIPTION OF THE DRAWINGS

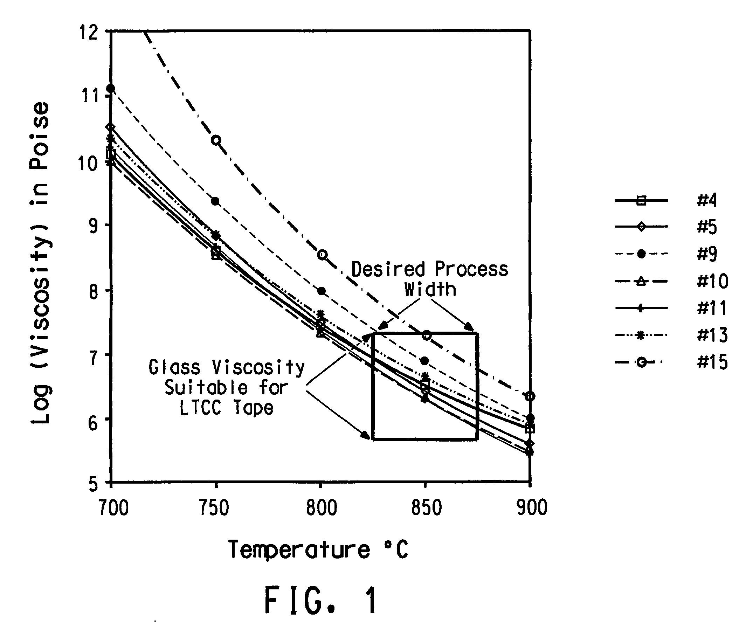

Figure 1 illustrates log viscosity versus temperature for selected glasses.

### DETAILED DESCRIPTION OF THE INVENTION

### GLASS

The present invention relates to an alkali-alkaline earth-alumino-borosilicate glass composition comprising, in mole %, 46-66% SiO₂, 3-9% Al₂O₃, 5-9% B₂O₃, 0-8% MgO, 1-6% SrO, 11-22% CaO, and 2-8% M wherein M is selected from oxides of the group of alkali elements and mixtures thereof. Alkali elements are found in group IA of the periodic table. For example, the alkali element oxide may be selected from Li₂O, Na₂O, K₂O and mixtures thereof. The molar ratio of SrO / (Ca + MgO) is between about 0.06 to about 0.45. This ratio range is necessary to assure compatibility properties with conductor materials used in conjunction with the LTCC tape of this invention.

The content of alkali and alkaline earth modifier in the glass is believed to increase the thermal expansion coefficient of glass while providing glass viscosity reduction critical to processing LTCC tape materials. Although the alkaline earth oxide, BaO, could be used to make an LTCC tape, it is found to reduce the chemical resistance, due to its ease of leaching in low pH solutions. For this reason, superior chemical resistance is found for alkaline earth modifier constituents within the ratio limits and mole percents defined above. Strontium oxide imparts superior solderability and low conductor resistivity in conductor material systems applied to outer layers of the tape. The content of strontium oxide in the glass, provides this improved conductor performance when present in the glass at levels including and exceeding 1 mole%. Data show that levels of 1 to 6 mole% provide improved conductor performance. A preferred level of strontium oxide is 1.8-3.0 mole%. The existence of the alkali oxides in the glass when used in a green tape improves the sensitivity of the glass to thermal process conditions by controlling the densification and crystallization behavior of the tape. The crucial role of the alkali addition is to provide required flow and densification characteristics to the tape at a desired firing temperature. It performs the function of glass viscosity reduction without affecting required physical and electrical performance of the tape. The type and amounts of alkali ions used to modify the viscosity properties of the glass also have an effect on the electrical loss characteristics of the tape made from the glass.

The glasses described herein may contain several other oxide constituents. For instance, ZrO₂, GeO₂, and P₂O₅ may be partially substituted for SiO₂ in the glass as follows, in mole% based on total glass composition: no more than 4 mole% ZrO₂, no more than 2 mole% P₂O₅, and no more than 1.5 mole% GeO₂. Additionally no more than 2.5 mole% CuO, based on mole total glass composition, may be partially substituted for the alkali and/or the alkaline earth constituents. Examples are SrO, MgO, CaO and mixtures thereof. A factor for the suitability of an LTCC tape formulation utilizing glass as a constituent is the required compatibility with conductors, and passive materials utilized as circuit components within and on the surface of the tape. This includes physical constraints such as suitable thermal expansion and the attainment of suitable levels of density and strength of the tape, the latter of which is enabled by the suitability of the glass viscosity to provide a tape in the required thermal processing temperature range.

The glasses described herein are produced by conventional glass making techniques. More particularly, the glasses may be prepared as follows. Glasses are typically prepared in 500-1000 gram quantities. Typically, the ingredients are weighted, then mixed in the desired proportions, and heated in a bottom-loading furnace to form a melt in a platinum alloy crucible. Heating is typically conducted to a peak temperature (1500-1550 °C) and for a time such that the melt becomes entirely liquid and homogeneous. The glass melts are then quenched by pouring on the surface of counter rotating stainless steel rollers to form a 10-20 mil (254 pm-508 µm) thick platelet of glass or by pouring into a water tank. The resulting glass platelet or water quenched frit is milled to form a powder with its 50% volume distribution set between 1-5 microns. The resulting glass powders are formulated with filler and medium into thick film pastes or castable dielectric compositions.

The glass when incorporated into a tape is compatible with co-fired thick film conductor materials. The glass in the tape does not flow excessively upon firing. This is due to the partial crystallization of the glass, which is initiated by the reaction between a ceramic filler, typically Agog, and the glass. The glass, which remains following the partial crystallization, is changed to a more refractory glass. This eliminates staining of the tape with the conductor material and allows solder wetting or chemical plating of the thick film conductor material. Solder wetting is an important feature to allow connection of the ceramic circuit to external wiring such as on a printed circuit board. If chemical plating of thick film conductors is applied to surface layers of the tape, low pH plating baths can release ions from the surface of the tape contaminating the plating bath. For this reason, the glass found in the tape minimizes the release of glass constituents by chemical corrosion in reduced pH solutions. Additionally, the glass found in the tape also minimizes the release of glass constituents by chemical corrosion in strong basic solutions.

### Castable Tape Composition

The tape composition is a castable dielectric composition which forms a tape. "Castable" as herein describes a means to deposit the composition by any suitable method. For example, the dielectric composition may be deposited by screen printing or any other suitable method. The castable dielectric composition comprises glass, ceramic filler, organic polymeric binder, and solvent.

The glass as described above is one component of the composition. The glass may be present in an amount of 22-46 wt.%, based on total dielectric composition. It forms a glass-ceramic structure during firing by forming crystalline phases. Ceramic filler such as Al₂O₃, ZrO₂, SiO₂, TiO₂ or mixtures thereof may be added to the castable dielectric composition in an amount of 20-60 wt.%, based on solids. The ceramic filler may be present in an amount of 11-35 wt.%, based on total dielectric composition. Depending on the type of filler, different crystalline phases are expected to form after firing. The filler can determine physical, thermal, mechanical and electrical properties.

Al₂O₃ may be used as the ceramic filler since it provides high mechanical strength and inertness against detrimental chemical reactions. Another function of the ceramic filler is rheological control of the entire system during firing. The ceramic particles limit flow of the glass by acting as a physical barrier. They also inhibit sintering of the glass and thus facilitate better burnout of the organics. Other fillers, α-quartz, CaZrO₃, mullite, cordierite, forsterite, zircon, zirconia, BaTiO₃, CaTiO₃, MgTiO₃, amorphous silica or mixtures thereof may also be used in the present invention to modify tape performance and characteristics. The amount of filler, type of filler and physical characteristics of the filler will influence the shrinkage of the fired green tape. Tape shrinkage may be adjusted to controlled levels by the use of a multi-modal particle size distribution optimized to reduce shrinkage by increasing filler packing density.

Useful LTCC green tapes can be fabricated from a glass/alumina composite having a wide range of glass/alumina ratios, depending on the properties desired in the fired article. For low glass/alumina ratios, the fired ceramic article is generally porous, due to insufficient glass being present to flow and surround the relatively inert alumina particles. The glass wetting and viscosity control this capacity to load filler without becoming porous. The porosity present may be desirable because of the lower dielectric constant of such an article compared to dense ceramics. On the other hand, porosity may be undesirable, if exposed to moist atmospheres. At high glass/alumina ratios, the fired article is smooth and dense, with little porosity. But excessive glass can lead to too little dimensional stability in the fired article, and in extreme cases can lead to warpage and distortion of the geometric features of the circuit. Excess glass can also migrate into cofired metallizations, glazing them and rendering them non-solderable. These trends and relationships are well known to those skilled in the art and the formulas used in the examples are not intended to be limiting. Alumina content of the tapes is not of the essence of this invention.

The interaction between the filler and the glass is also subject to change when alternative fillers are used. It is possible by inappropriate choice of fillers to render the LTCC tape unsuitable for some applications.

In the formulation of tape compositions, the amount of glass relative to the amount of ceramic material is important. A filler range of 20-60% by weight solids is considered desirable in that sufficient densification is achieved. If the filler concentration exceeds 60% by wt., the fired structure is not sufficiently densified and is too porous. Within the desirable glass/filler ratio, it will be apparent that, during firing, the liquid glass phase will become saturated with filler material.

For the purpose of obtaining higher densification of the composition upon firing, it is important that the inorganic solids have small particle sizes. In particular, substantially all of the particles should not exceed 15 µm and preferably not exceed 10 µm. Subject to these maximum size limitations, it is preferred that at least 50% of the particles, both glass and ceramic filler, be greater than 1 µm and less than 6 µm.

The organic medium in which the glass and ceramic inorganic solids (ceramic filler) are dispersed is comprised of a polymeric binder which is dissolved in a volatile organic solvent and, optionally, other dissolved materials such as plasticizers, release agents, dispersing agents, stripping agents, antifoaming agents, stabilizing agents and wetting agents.

The organic polymeric binder may be present in an amount of 5-8 wt.% based on total dielectric composition. It is preferred to use at least 5% wt. polymeric binder for 60% wt. solids, which includes glass and ceramic filler, based on total composition. Within these limits, it is desirable to use the least possible amount of binder and other low volatility organic modifiers, in order to reduce the amount of organics which must be removed by pyrolysis, and to obtain better particle packing which facilitates full densification upon firing.

In the past, various polymeric materials have been employed as the binder for green tapes, e.g., poly(vinyl butyral), poly(vinyl acetate), poly(vinyl alcohol), cellulosic polymers such as methyl cellulose, ethyl cellulose, hydroxyethyl cellulose, methylhydroxyethyl cellulose, atactic polypropylene, polyethylene, silicon polymers such as poly(methyl siloxane), poly(methylphenyl siloxane), polystyrene, butadiene/styrene copolymer, polystyrene, poly(vinyl pyrollidone), polyamides, high molecular weight polyethers, copolymers of ethylene oxide and propylene oxide, polyacrylamides, and various acrylic polymers such as sodium polyacrylate, poly(lower alkyl acrylates), poly(lower alkyl methacrylates) and various copolymers and multipolymers of lower alkyl acrylates and methacrylates. Each of these listed polymeric binders, as well as similar polymeric binders, is suitable in the present invention. Copolymers of ethyl methacrylate and methyl acrylate and terpolymers of ethyl acrylate, methyl methacrylate and methacrylic acid have been previously used as binders for slip casting materials. Each of these binders, as well as similar binders, is suitable in the present invention.

US Patent No. 4,536,535 to Usala, issued August 20, 1985, has disclosed an organic binder which is a mixture of compatible multipolymers of 0-100% wt. C₁₋₈ alkyl methacrylate, 100-0% wt. C₁₋₈ alkyl acrylate and 0-5% wt. ethylenically unsaturated carboxylic acid of amine. Because the above polymers can be used in minimum quantity with a maximum quantity of dielectric solids, they are preferably selected to produce the dielectric compositions of this invention. For this reason, the disclosure of the above-referred Usala application is incorporated by reference herein.

The solvent component of the casting solution is chosen so as to obtain sufficiently complete dissolution of the polymer and sufficiently high volatility to enable the solvent to be evaporated from the dispersion by the application of relatively low levels of heat at atmospheric pressure. The solvent is present in an amount of 30-45 wt.% based on total composition. In addition, the solvent must boil well below the boiling point or the decomposition temperature of any other additives contained in the organic medium. Thus, solvents having atmospheric boiling points below 150°C are used most frequently. Such solvents include, but are not limited to, acetone, xylene, methanol, ethanol, isopropanol, methyl ethyl ketone, ethyl acetate, 1,1,1-trichloroethane, tetrachloroethylene, amyl acetate, 2,2,4-triethyl pentanediol-1,3-monoisobutyrate, toluene, methylene chloride and fluorocarbons. Individual solvents mentioned above may not completely dissolve the binder polymers. Yet, when blended with other solvent(s), they function satisfactorily. This is well within the skill of those in the art. A particularly preferred solvent is ethyl acetate, since it avoids the use of environmentally hazardous chlorocarbons.

Frequently, the dielectric composition will also contain a small amount, relative to the polymeric binder, of a plasticizer that serves to lower the glass transition temperature (Tg) of the binder polymer. The choice of plasticizers, of course, is determined primarily by the polymer that needs to be modified. Among the plasticizers which have been used in various binder systems are diethyl phthalate, dibutyl phthalate, dioctyl phthalate, butyl benzyl phthalate, alkyl phosphates, polyalkylene glycols, glycerol, poly(ethylene oxides), hydroxyethylated alkyl phenol, dialkyldithiophosphonate and poly(isobutylene). For example, each of these plasticizers is suitable in the present invention. Of these, butyl benny! phthalate is most frequently used in acrylic polymer systems because it can be used effectively in relatively small concentrations.

As noted above, in addition to the solvent and polymeric binder, a plasticizer may be used to prevent tape cracking and provide wider latitude of as-coated tape handling ability such as blanking, printing, and lamination. For example, BENZOFLEX® 400, a plasticizer manufactured by Rohm and Haas Co., which is polypropylene glycol dibenzoate may be used. The materials used herein are characterized by their freedom of toxic metal oxides. The materials are designed to be processed at a temperature of about 825-900°C degree. The tape is designed to co-fire with conductors and other passive electrical components applied by standard methods including, screen printing and tape laminating.

The tape exhibits a uniform and low dielectric constant (<10 in the case of Al₂O₃ fillers) with low electrical loss performance over a broad range of frequency range (up to 13 GHz). The tape is chemically resistant to acidic plating baths used for metal addition to a base layer of printed conductive.

### Application

A green tape is formed by casting a thin layer of a slurry dispersion of the glass, ceramic filler, polymeric binder and solvent(s) as described above onto a flexible substrate and heating the cast layer to remove the volatile solvent. It is preferred that the tape not exceed 20 mils (508 µm) in thickness and preferably 1 to 10 mils (25.4-254 µm). The tape is then blanked into sheets or collected in a roll form. The green tape is typically used as a dielectric or insulating material for multilayer electronic circuits. A sheet of green tape is blanked with registration holes in each corner to a size somewhat larger than the actual dimensions of the circuit. To connect various layers of the multilayer circuit, via holes are formed in the green tape. This is typically done by mechanical punching, however, any suitable method may be utilized. However, for example, a sharply focused laser can be used to volatilize and form via holes in the green tape. Typical via hole sizes range from 0.004" to 0.25" (0.1-6.35 mm). The interconnections between layers are formed by filling the via holes with a thick film conductive ink. This ink is usually applied by standard screen printing techniques, however, any suitable application technique may be employed. Each layer of circuitry is typically completed by screen printing conductor tracks. Also, resistor inks or high dielectric constant inks can be printed on selected layer(s) to form resistive or capacitive circuit elements. Furthermore, specially formulated high dielectric constant green tapes similar to those used in the multilayer capacitor industry can be incorporated as part of the multilayer circuitry.

After each layer of the circuit is completed, the individual layers are collated and laminated. A confined uniaxial or isostatic pressing die is used to insure precise alignment between layers. The laminate assemblies are trimmed with a hot stage cutter. Firing is carried out in a standard thick film conveyor belt furnace or in a box furnace with a programmed heating cycle. The tape may be either constrained or free sintered during its thermal processing, "firing".

As used herein, the term "firing" means heating the assembly in an oxidizing atmosphere, such as air to a temperature, and for a time sufficient to volatilize (burn-out) the organic material in the layers of the assemblage. The "firing" causes any glass, metal or dielectric material in the layers, to sinter, and thus densify the entire assembly, thus forming a fired article.

It will be recognized by those skilled in the art that in each of the laminating steps the layers must be accurate in registration so that the vias are properly connected to the appropriate conductive path of the adjacent functional layer.

The term "functional layer" refers to the printed green tape, which has conductive, resistive or capacitive functionality. Thus, as indicated above, a typical green tape layer may have printed thereon one or more resistor circuits and/or capacitors as well as conductive circuits.

It may be further desired to apply the compositions of the invention as a thick film paste by such techniques as screen printing. In this event, the composition must have an appropriate viscosity so as to pass readily through the screen. The thick film composition comprises functional solids dispersed in an organic medium that acts as a carrier for the functional phase. The organic medium in which the glass and ceramic inorganic solids (ceramic filler) are dispersed is comprised of the polymeric binder which is dissolved in a volatile organic solvent and, optionally, other dissolved materials such as plasticizers, release agents, dispersing agents, stripping agents, antifoaming agents and wetting agents.

The solids are typically mixed with an organic medium by mechanical mixing to form a pastelike composition, called "pastes", having suitable consistency and rheology for printing. A wide variety of inert liquids can be used as organic medium. The organic medium must be one in which the solids are dispersible with an adequate degree of stability. The rheological properties of the medium must be such that they lend good application properties to the composition. Such properties include: dispersion of solids with an adequate degree of stability, good application of composition, appropriate viscosity, thixotropic, appropriate wettability of the substrate and the solids, a good drying rate, good firing properties, and a dried film strength sufficient to withstand rough handling. The organic medium is conventional in the art and is typically a solution of the polymer in solvent(s). The most frequently used resin for this purpose is ethyl cellulose. Other examples of resins include ethylhydroxyethyl cellulose, wood rosin, mixtures of ethyl cellulose and phenolic resins, polymethacrylates of lower alcohols, and monobutyl ether of ethylene glycol monoacetate can also be used. The most widely used solvents found in thick film compositions are ethyl acetate and terpenes such as alpha- or beta-terpineol or mixtures thereof with other solvents such as kerosene, dibutylphthalate, butyl carbitol, butyl carbitol acetate, hexylene glycol and high boiling alcohols and alcohol esters. In addition, volatile liquids for promoting rapid hardening after application on the substrate can be included in the vehicle. The preferred mediums are based on ethylcellulose and β-terpineol. Various combinations of these and other solvents are formulated to obtain the viscosity and volatility requirements desired.

The present invention will be described in further detail by giving practical examples. The scope of the present invention, however, is not limited in any way by these practical examples.

### EXAMPLES

### EXAMPLES 1-18

A series of alkali-alkaline earth-alumino-borosilicate glass compositions that have been found to be suitable in the present invention for application to LTCC tape are shown in Table 1 (Glass #'s 1-5 and 7-14). Glasses #6 and #15-18 in Table 1 represent non-Strontium oxide containing glass. All glasses were prepared by mixing raw materials and then firing in a platinum crucible at 1500-1550°C. The resulting melt was mixed and quenched by pouring on the surface of counter rotating stainless steel rollers or into a water tank. The glass powders prepared for the invention were adjusted to a 5-7 micron mean size by ball milling prior to formulation as a slip. The mill slurry is dried in a hot air oven and deagglomerated by screening. Since additional milling is utilized in the fabrication of tape slip, the final mean size is normally in the range of 1-3 microns.

**Table 1. Glass compositions in mole %**

| Glass # | SiO₂ | Al₂O₃ | B₂O₃ | CaO | MgO | Na₂O | Li₂O | SrO | K₂O | CuO | Density g/cc |
|---|---|---|---|---|---|---|---|---|---|---|---|
| 1 | 65.88 | 6.80 | 5.31 | 12.13 | 1.12 | 3.14 | 0.87 | 2.60 | 2.13 | | 2.53 |
| 2 | 65.28 | 3.96 | 8.24 | 12.97 | | 1.80 | | 5.40 | 2.34 | | 2.53 |
| 3 | 64.32 | 4.36 | 8.27 | 13.39 | | 2.10 | | 5.49 | 2.07 | | 2.61 |
| 4 | 64.27 | 6.89 | 6.58 | 12.28 | 1.14 | 3.18 | 0.88 | 2.63 | 2.16 | | 2.52 |
| 5 | 64.27 | 5.69 | 7.78 | 12.28 | 1.14 | 3.18 | 0.88 | 2.63 | 2.16 | | 2.52 |
| 6 | 57.45 | 8.62 | 8.11 | 19.58 | 5.45 | | | | | 0.79 | 2.56 |
| 7 | 58.81 | 7.25 | 6.83 | 17.76 | 1.59 | 2.59 | 0.75 | 2.79 | 1.02 | 0.61 | 2.60 |
| 8 | 58.20 | 7.74 | 6.85 | 17.82 | 1.60 | 2.60 | 0.76 | 2.80 | 1.03 | 0.61 | 2.72 |
| 9 | 58.64 | 7.88 | 7.55 | 18.73 | 1.53 | 2.33 | 0.54 | 1.79 | 1.02 | | 2.54 |
| 10 | 58.15 | 8.00 | 7.66 | 19.02 | 1.56 | 2.28 | 0.52 | 1.82 | 1.00 | | 2.55 |
| 11 | 57.66 | 8.09 | 7.75 | 19.24 | 1.57 | 2.30 | 0.53 | 1.84 | 1.01 | | 2.57 |
| 12 | 57.47 | 8.86 | 7.88 | 18.41 | 1.60 | 2.34 | 0.54 | 1.87 | 1.03 | | 2.55 |
| 13 | 57.17 | 8.19 | 7.84 | 19.46 | 1.59 | 2.33 | 0.54 | 1.86 | 1.02 | | 2.53 |
| 14 | 57.15 | 8.12 | 7.84 | 19.30 | 1.59 | 2.59 | 0.54 | 1.86 | 1.02 | | 2.56 |

The glass density has been measured by the Archemedes method utilizing the volume displacement when a glass sample is weighed while suspended in water and dried to compute its density in grams per cubic centimeter. The glass viscosity data has been measured using the parallel plate method that measures a dense bulk glass sample cast and cut from an annealed glass sample. The technique measures the rate of deformation of a glass cylinder shaped specimen under an actively maintained loading. The technique is suitable for measurements in the range of log (viscosity) between 5 and 10 poise (0.1-1 Pa.s). This relation for some of the selected glasses in Table 2 is shown in Figure 1.

The plot has a rectangular region outlined to show the window of acceptable viscosity-temperature for LTCC applications.

**Table 2. Glass Viscosity Data**

| | | | Log(Glass | | | | | | |
|---|---|---|---|---|---|---|---|---|---|
| | | | Viscosity) | | | | | | |
| Temperature | #4 | #5 | #9 | #10 | #11 | #13 | #15 | #16 | #17 |
| °C | | | | | | | | | |
| 700.00 | 10.08 | 10.66 | 11.18 | 10.02 | 10.37 | 10.50 | 12.80 | 10.73 | 10.19 |
| 750.00 | 8.60 | 8.90 | 9.35 | 8.47 | 8.65 | 8.90 | 10.46 | 9.00 | 8.74 |
| 800.00 | 7.44 | 7.56 | 7.95 | 7.27 | 7.33 | 7.66 | 8.71 | 7.67 | 7.61 |
| 850.00 | 6.52 | 6.52 | 6.86 | 6.33 | 6.31 | 6.68 | 7.37 | 6.64 | 6.70 |
| 900.00 | 5.78 | 5.69 | 6.00 | 5.57 | 5.50 | 5.90 | 6.33 | 5.81 | 5.97 |

### GLASS EXAMPLES 19-32

Examples 19-32, as shown in Table 3, denote glass compositions of the present invention, which contain ZrO₂, GeO₂ and P₂O₅ as partial substitutions for SiO₂. The procedure of glass preparation and the characterization techniques are identical with what is described in the previous examples in Table 1.

**Table 3. Glass compositions in mole %**

| Glass # | SiO₂ | Al₂O₃ | ZrO₂ | B₂O₃ | CaO | CuO | MgO | Na₂O | Li₂O | SrO | GeO₂ | P₂O 5 | K₂O | Density g/cc |
|---|---|---|---|---|---|---|---|---|---|---|---|---|---|---|
| 19 | 58.13 | 5.79 | 3.66 | 7.92 | 12.50 | | 1.16 | 3.24 | 0.90 | 2.68 | | 1.83 | 2.20 | 2.62 |
| 20 | 57.59 | 5.23 | | 7.90 | 16.15 | 2.03 | 2.73 | 3.13 | 0.54 | 1.87 | | 1.59 | 1.24 | 2.56 |
| 21 | 57.55 | 6.18 | | 7.89 | 16.13 | 1.63 | 3.21 | 2.61 | 0.54 | 1.87 | | 1.37 | 1.03 | 2.53 |
| 22 | 57.43 | 8.00 | | 7.20 | 19.48 | | 1.59 | 2.33 | 0.75 | 1.86 | | 0.32 | 1.02 | 2.59 |
| 23 | 56.57 | 7.82 | | 6.91 | 17.98 | 0.61 | 1.61 | 2.62 | 0.76 | 2.83 | 1.24 | | 1.04 | 2.62 |
| 24 | 55.65 | 6.48 | 3.08 | 8.14 | 13.57 | | 1.23 | 2.38 | 0.66 | 3.08 | | 1.54 | 4.17 | 2.62 |
| 25 | 55.42 | 8.13 | | 7.83 | 14.46 | | 7.83 | 2.17 | 0.54 | 1.81 | | 0.60 | 1.20 | 2.55 |
| 26 | 55.29 | 7.55 | 1.20 | 7.54 | 16.50 | 0.40 | 4.32 | 2.17 | 0.55 | 2.41 | | 0.60 | 1.47 | 2.60 |
| 27 | 52.73 | 7.60 | | 8.05 | 21.84 | | 1.94 | 2.23 | 0.55 | 2.51 | | 1.10 | 1.45 | 2.62 |
| 28 | 52.41 | 7.74 | 1.19 | 7.74 | 16.68 | 1.19 | 6.43 | 2.20 | 0.54 | 2.98 | | 0.60 | 0.30 | 2.67 |
| 29 | 50.93 | 7.81 | 1.44 | 7.81 | 16.82 | 1.68 | 6.01 | 2.52 | 0.54 | 3.00 | | 0.84 | 0.60 | 2.65 |
| 30 | 50.60 | 7.83 | 1.57 | 7.83 | 16.87 | 1.57 | 5.30 | 2.65 | 0.54 | 3.61 | | 1.02 | 0.60 | 2.68 |
| 31 | 48.63 | 7.90 | | 7.90 | 17.02 | 1.82 | 7.29 | 2.74 | 0.61 | 3.65 | | 1.82 | 0.61 | 2.67 |
| 32 | 46.94 | 7.88 | 1.58 | 7.88 | 16.98 | 1.82 | 6.55 | 3.27 | 0.61 | 4.85 | | 1.03 | 0.61 | 2.78 |

### EXAMPLES 33-37

In Examples 33-37 the ceramic tape was prepared by dispersing powders of glass and ceramic filler in an ethyl acetate solvent with methylmethacrylate, methacrylic acid copolymer binder and plasticizer. The plasticizer used was BENZOFLEX provided by Rohm and Haas Co. Table 4 discloses tape compositions utilizing the glasses of Table 1. The desirable quantity of the organic solvent and/or solvent blend was determined to obtain an effective slip milling and coating performance. More specifically, the composition for the slip must include sufficient solvent to lower the viscosity to less than 10,000 centipoise (10 Pa.s); typical viscosity ranges are 1,000 to 4,000 centipoise (1-4 Pa.s). Depending on the chosen slip viscosity, higher viscosity slip prolongs the dispersion stability for a longer period of time. A stable dispersion of tape constituents is usually preserved in the as-coated tape.

Solid composition of tape was further optimized using various ratios of glass/ceramic filler until the point of full densification was achieved yet without excessive glass to keep dimensional stability good after firing. If needed, a preferred inorganic pigment at weight % of 0.0 to 2.0 may be added to the above slip composition before the milling process.

The slip was cast on a Mylar sheet and dried to form a tape. The tape was cut, laminated, printed with thick film silver and fired in a conventional profile with an 850°C/10 min peak. The ceramic fired dense with a high x, y shrinkage of 11 to 16% and showed no stains with co-fired silvers. Table 4 represents the characteristics of fired tapes. The final tape showed good dimensional stability and no distortion or cracks along the pattern of co-fired 6142D (pure Ag) and 6146 (Pd-Ag) conductors, which are commercially available from DuPont. The co-fired 6146 Pd-Ag conductor particularly showed good wetting of conventional solder and excellent solderability.

Low frequency dielectric characteristics were evaluated using an impedance analyzer (Hewlett Packard 4192A) within the frequency range of 1 kHz to 13 MHz. For the low frequency range, dielectric constant ranged from 7 to 9 and loss tangent was quite stable less than 0.2% as shown in Table 4. To measure dielectric constant at high frequency above 1 GHz up to 13 GHz, a 50 Ω strip pattern was prepared on the tape by post-firing a silver conductor and ground planes. Measurements were made using a Hewlett Packard 8510B Microwave Network Analyzer. The resulting dielectric constant was near 8 in the range of 1 GHz to 10 GHz. No significant variation in the dielectric constant was observed over the frequency range.

In addition, chemical leaching of the tape was evaluated in two different strong chemical solutions of 10% HCl and 10% H₂SO₄. Each sample of approximately 1"x1" (2.5 x 2.5 cm) (with a thickness of 0.02" to 0.04" (0.05 to 0.10 cm)) was immersed in a bath of chemical solution for 30 minutes at a temperature of 35°C. As shown in Table 4, the performance of the chemical durability was recorded as weight change of each sample before and after the immersion. Data shows values less than 0.5% weight change regardless of the acid and base solutions, which is very promising for applications utilizing plateable conductors. Typically weight loss of less than 1% is considered acceptable under the above conditions of testing.

**Table 4. Tape compositions (weight %) and characteristics.**

| Ex. # | 33 | 34 | 35 | 36 | 37 |
|---|---|---|---|---|---|
| Glass # 9 | 30.4 | | | | |
| Glass # 10 | | 32.1 | 30.4 | | |
| Glass # 11 | | | | 32.1 | |
| Glass # 13 | | | | | 30.4 |
| Alumina | 25.9 | 24.2 | 25.9 | 24.2 | 25.9 |
| Co aluminate | 0.3 | 0.3 | 0.3 | 0.3 | 0.3 |
| Acrylic Polymer | 6.2 | 6.2 | 6.2 | 6.2 | 6.2 |
| Solvent | 36.1 | 36.1 | 36.1 | 36.1 | 36.1 |
| Plasticizer | 1.1 | 1.1 | 1.1 | 1.1 | 1.1 |
| 6146 solderable | Yes | Yes | Yes | Yes | Yes |
| Dielectric constant (1 MHz) | 8.2 | 7.9 | 8.1 | 8.0 | 8.1 |
| Loss tangent (1 MHz) | 0.0015 | 0.0015 | 0.0016 | 0.0014 | 0.0016 |
| Weight loss in 10% HCl | 0.24% | 0.32% | 0.30% | - | - |
| Weight loss in 10% H₂SO₄ | 0.30% | 0.38% | 0.38% | - | - |

### EXAMPLE 38-41

In Examples 38-40 the ceramic tape was prepared by mixing the Glass # 16 with alumina filler. The tape was processed in the same way as described in Examples 33-37. The same polymer, solvent and plasticizer as used in Examples 33-37 were used. The Glass #16 represents a glass without SrO. The addition of SrO has proved critical to Ag-based conductor compatibility. The resulting tape did not show good compatibility with co-fired 6146 (Ag/Pd) conductor in terms of solderability, even though similar dielectric properties were obtained. The absence of SrO in the glass appears to allow detrimental chemical reactions to occur with the conductors, which can generate poor solderability. Examples 38 and 39 both use glass #16 with two alumina filler levels. There is a slight change in the dielectric constant due to the added alumina, but both show unsatisfactory solderability. Two additional glasses #17 and #18 with no SrO content are shown in examples 40 and 41. In spite of the glass viscosities for glass #16 and #17 being within the same range as the other glasses shown in Table 2, the conductor compatibility shown in the series of examples 38 to 41 continues as unsatisfactory. The previous examples 33-37 using glasses that contain sufficient content of SrO are all suitable for conductor compatibility.

| Ex. # | 38 | 39 | 40 | 41 |
|---|---|---|---|---|
| Glass # 16 | 42.3 | 36.2 | | |
| Glass # 17 | | | 36.2 | |
| Glass # 18 | | | | 30.9 |
| Alumina | 18.1 | 24.2 | 24.2 | 27.4 |
| Acrylic Polymer | 6.6 | 6.6 | 6.6 | 6.4 |
| Solvent | 31.8 | 31.8 | 31.8 | 34.1 |
| Plasticizer | 1.2 | 1.2 | 1.2 | 1.2 |
| 6146 solderable | No | No | No | No |
| Dielectric constant (1 MHz) | 8.0 | 8.1 | 7.7 | 8.0 |
| Loss tangent (1 MHz) | 0.0015 | 0.0014 | 0.0016 | 0.0015 |

### EXAMPLES 42-45

Again, the same polymer, solvent and plasticizer as described in Examples 33-37 were used. The examples in this series were tested as follows: A single sheet of the green tapes tabulated below was printed with DuPont 6142D Ag composition in a geometric pattern having parallel lines and right angles. The printed sheet was stacked in registry with 7 other blank pieces of green tape and laminated in a heated press at 70°C and 3000 psi pressure. The laminate was fired to a peak temperature of 850°C, held for at least 10 minutes, and cooled to room temperature. The fired article was observed to be >90% dense and to have undergone isomorphic shrinkage such that straight lines remained straight and angles between features were unchanged.

A similar part was made substituting Dupont 6146 Pud-wag composition for 6142D. DuPont 6146 is sold as a solderable composition, and it was found that it was indeed solderable on the tapes of this example.

A blank 8-layer laminate was made without printing cofired conductors on any of the layers. After firing to a peak temperature of 850C, the broad top and bottom surfaces were metallized with 6142D to form a capacitor, and the capacitance and loss tangent of the capacitor was measured on a Hewlett-Packard Model HP4284A LCR Meter at a frequency of 1 MHz. From the capacitance and a measurement of the dimensions of the capacitor, the dielectric constant was calculated.

| Ex. # | 42 | 43 | 44 | 45 |
|---|---|---|---|---|
| Glass # 5 | 36.30 | 34.60 | 31.10 | |
| Glass # 24 | | | | 39.90 |
| Alumina | 21.20 | 23.30 | 27.50 | 13.00 |
| Acrylic Polymer | 7.00 | 6.90 | 6.80 | 7.80 |
| Solvent | 33.80 | 33.50 | 32.90 | 37.40 |
| Plasticizer | 1.70 | 1.70 | 1.70 | 1.90 |
| 6146 solderable | YES | YES | YES | YES |
| Dielectric constant (1 MHz) | 8.10 | 7.70 | 7.90 | 8.20 |
| Loss Tangent (1 MHz) | 0.0021 | 0.0018 | 0.0015 | 0.0026 |

Both glasses in these examples contain sufficient SrO to provide solderable conductors. The glass #24 in example 45 is an example of a substantial substitution of ZrO₂ and P₂O₅ for SiO₂ in the glass. In this case, the capacity to use alumina filler is reduced by an apparent increase in glass viscosity due to the level of substitution.

## Claims

1. A glass composition comprising, in mole %, 2-8% M, wherein M is selected from an oxide of the group of alkali elements and mixtures thereof, 46-66% SiO₂, 3-9% Al₂O₃, 5-9% B₂O₃, 0-8% MgO, 1-6% SrO and 11-22% CaO wherein the molar ratio of SrO /(MgO + CaO) is between 0.06 and 0.45.

2. The composition of Claim 1 wherein SiO₂ is partially replaced by an oxide selected from the group of ZrO₂, P₂O₅, GeO₂ and mixtures thereof wherein the composition comprises of no more than 4% ZrO₂, no more than 2% P₂O₅, and no more than 1.5% GeO₂ in mole % of the total composition.

3. The composition of Claim 1 wherein any one of the group selected from SrO, MgO. CaO and mixtures thereof are partially replaced by CuO wherein the composition comprises no more than 2.5 mole % CuO in mole % of the total glass composition.

4. The composition of Claim 1 wherein M, is selected from Na₂O, Li₂O, K₂O, CuO, and mixtures thereof with the proviso that CuO is 0-2.5 mole % of the total glass composition.

5. A powder composition comprising a mixture of finely divided solids comprising,
(a) 40-80 wt.% glass composition as in any one of claims 1-4; and
(b) 20-60 wt% ceramic filler.

6. A thick film composition comprising a dispersion of finely divided solids comprising,
(a) glass composition as in any one of claims 1-4;
(b) ceramic filler, and
(c) organic medium.

7. A castable dielectric composition comprising a dispersion of finely divided solids comprising, based on total composition:
(a) 22-46 wt. % glass composition as in any one of claims 1-4;
(b) 11-35 wt. % ceramic filler;
(c) 5-8 wt.% organic polymeric binder, and
(d) 30-45 wt. % volatile organic solvent.

8. The dielectric composition of Claim 7 wherein the ceramic filler is selected from Al₂O₃, ZrO₂, TiO₂, BaTiO₃, and mixtures thereof.

9. A green tape formed by casting a layer of the dielectric composition of Claim 7 onto a flexible substrate forming a cast layer, and heating the cast layer to remove the volatile organic solvent forming a solvent free layer.

10. The tape of Claim 9 wherein the solvent-free layer is separated from the substrate.

11. The tape of Claim 9 wherein a conductor composition is deposited on the tape.

12. The tape of Claim 10 wherein a conductor composition is deposited on the tape.

13. An article comprising the tape of Claim 9 wherein the tape is processed to volatilize the organic polymeric binder and sinter the glass composition.

14. An article comprising the tape of Claim 10 wherein the tape is processed to volatilize the organic polymeric binder and sinter the glass composition.

## Patentansprüche

1. Glaszusammensetzung, die in Mol% aufweist: 2-8 % M, wobei M unter einem Oxid der Gruppe der Alkalielemente oder Gemischen davon ausgewählt ist, 46-66 % SiO₂, 3-9 % Al₂O₃, 5-9 % B₂O₃, 0-8 % MgO, 1-6 % SrO und 11-22 % CaO, wobei das Molverhältnis von SrO/(MgO + CaO) zwischen 0,06 und 0,45 liegt.

2. Zusammensetzung nach Anspruch 1, wobei SiO₂ teilweise durch ein aus der Gruppe ZrO₂, P₂O₅, GeO₂ und Gemischen davon ausgewähltes Oxid ausgetauscht wird, wobei die Zusammensetzung nicht mehr als 4 % ZrO₂, nicht mehr als 2 % P₂O₅ und nicht mehr als 1,5 % GeO₂ in Mol-% der gesamten Zusammensetzung aufweist.

3. Zusammensetzung nach Anspruch 1, wobei irgendeines ausgewählt aus der Gruppe SrO, MgO, CaO und Gemischen davon teilweise durch CuO ausgetauscht wird, wobei die Zusammensetzung nicht mehr als 2,5 Mol-% CuO in Mol-% der gesamten Glaszusammensetzung aufweist

4. Zusammensetzung nach Anspruch 1, wobei M unter Na₂O, Li₂O, K₂O, CuO und Gemischen davon ausgewählt ist, unter dem Vorbehalt, daß CuO 0-2,5 Mol-% der gesamten Glaszusammensetzung bildet.

5. Pulverzusammensetzung mit einem Gemisch aus feinverteilten Feststoffen, die aufweist:
(a) 40-80 Gew.-% einer Glaszusammensetzung nach einem der Ansprüche 1-4; und
(b) 20-60 Gew.-% keramischen Füllstoff.

6. Dickschicht-Zusammensetzung mit einer Dispersion von feinverteilten Feststoffen, die aufweist:
(a) eine Glaszusammensetzung nach einem der Ansprüche 1-4;
(b) keramischen Füllstoff; und
(c) ein organisches Medium.

7. Gießbare dielektrische Zusammensetzung mit einer Dispersion von feinverteilten Feststoffen, die aufweist, bezogen auf die gesamte Zusammensetzung:
(a) 22-46 Gew.-% einer Glaszusammensetzung nach einem der Ansprüche 1-4;
(b) 11-35 Gew.-% keramischen Füllstoff;
(c) 5-8 Gew.-% organisches polymeres Bindemittel; und
(d) 30-45 Gew.-% flüchtiges organisches Lösungsmittel.

8. Dielektrische Zusammensetzung nach Anspruch 7, wobei der keramische Füllstoff unter Al₂O₃, ZrO₂, TiO₂, BaTiO₃ und Gemischen davon ausgewählt ist.

9. Ungebranntes Band, geformt durch Gießen einer Schicht aus der dielektrischen Zusammensetzung nach Anspruch 7 auf ein flexibles Substrat, wodurch eine gegossene Schicht geformt wird, und Erhitzen der gegossenen Schicht, um das flüchtige organische Lösungsmittel zu entfernen und eine lösungsmittelfreie Schicht zu bilden.

10. Band nach Anspruch 9, wobei die lösungsmittelfreie Schicht von dem Substrat abgetrennt wird.

11. Band nach Anspruch 9, wobei eine Leiterzusammensetzung auf das Band aufgebracht wird.

12. Band nach Anspruch 10, wobei eine Leiterzusammensetzung auf das Band aufgebracht wird.

13. Artikel, der das Band nach Anspruch 9 aufweist, wobei das Band verarbeitet wird, um das organische polymere Bindemittel zu verflüchtigen und die Glaszusammensetzung zu sintern.

14. Artikel, der das Band nach Anspruch 10 aufweist, wobei das Band verarbeitet wird, um das organische polymere Bindemittel zu verflüchtigen und die Glaszusammensetzung zu sintern.

## Revendications

1. Composition de verre comprenant, en % en moles, 2 à 8% de M, où M est choisi parmi un oxyde du groupe des éléments alcalins et de mélanges de ceux-ci, 46 à 66% de SiO₂, 3 à 9% de Al₂O₃, 5 à 9% de B₂O₃, 0 à 8% de MgO, 1 à 6% de SrO et 11 à 22% de CaO, où le rapport molaire de SrO/(MgO+CaO) est entre 0,06 et 0,45.

2. Composition selon la revendication 1, dans laquelle SiO₂ est partiellement remplacé par un oxyde choisi dans le groupe de ZrO₂, P₂O₅, GeO₂ et des mélanges de ceux-ci, laquelle composition ne comprend pas plus de 4% de ZrO₂, pas plus de 2% de P₂O₅ et pas plus de 1,5% de GeO₂ en % en moles de la composition totale.

3. Composition selon la revendication 1, dans laquelle tous ingrédients du groupe choisi parmi SrO, MgO, CaO et des mélanges de ceux-ci sont partiellement remplacés par CuO, laquelle composition ne comprend pas plus de 2,5% en moles de CuO en % en moles de la composition de verre totale.

4. Composition selon la revendication 1, dans laquelle M est choisi parmi Na₂O, Li₂O, K₂O, CuO et des mélanges de ceux-ci, avec pour condition que CuO représente 0 à 2,5% en moles de la composition de verre totale.

5. Composition de poudre comprenant un mélange de matières solides finement divisées, comprenant
(a) 40 à 80% en poids de composition de verre selon l'une quelconque des revendications 1 à 4; et
(b) 20 à 60% en poids de charge céramique.

6. Composition en film épais comprenant une dispersion de matières solides finement divisées, comprenant
(a) une composition de verre selon l'une quelconque des revendications 1 à 4;
(b) une charge céramique; et
(c) un milieu organique.

7. Composition diélectrique coulable comprenant une dispersion de matières solides finement divisées comprenant, par rapport à la composition totale:
(a) 22 à 46% en poids de composition de verre selon l'une quelconque des revendications 1 à 4;
(b) 11 à 35% en poids de charge céramique;
(c) 5 à 8% en poids de liant polymère organique; et
(d) 30 à 45% en poids de solvant organique volatil.

8. Composition diélectrique selon la revendication 7, dans laquelle la charge céramique est choisie parmi Al₂O₃, ZrO₂, TiO₂, BaTiO₃, et des mélanges de ceux-ci.

9. Bande verte formée en coulant une couche de la composition diélectrique selon la revendication 7 sur un substrat flexible formant une couche coulée, et en chauffant la couche coulée pour enlever le solvant organique volatil formant une couche exempte de solvant.

10. Bande selon la revendication 9, dans laquelle la couche exempte de solvant est séparée du substrat.

11. Bande selon la revendication 9, dans laquelle une composition de conducteur est déposée sur la bande.

12. Bande selon la revendication 10, dans laquelle une composition de conducteur est déposée sur la bande.

13. Article comprenant la bande selon la revendication 9, dans lequel la bande est traitée pour volatiliser le liant polymère organique et fritter la composition de verre.

14. Article comprenant la bande selon la revendication 10, dans lequel la bande est traitée pour volatiliser le liant polymère organique et fritter la composition de verre.
